**Europäisches Patentamt**

**European Patent Office**

**Office européen des brevets**

(11) Numéro de publication : **0 283 367 B1**

(12) **FASCICULE DE BREVET EUROPEEN**

(45) Date de publication du fascicule du brevet :
**22.01.92 Bulletin 92/04**

(51) Int. Cl.$^5$ : **H05K 3/34,** B23K 3/06

(21) Numéro de dépôt : **88400476.3**

(22) Date de dépôt : **01.03.88**

(54) **Machine de soudage à l'étain avec pare-vague automatique, pour cartes à circuit imprimé.**

(30) Priorité : **03.03.87 FR 8702836**

(43) Date de publication de la demande :
**21.09.88 Bulletin 88/38**

(45) Mention de la délivrance du brevet :
**22.01.92 Bulletin 92/04**

(84) Etats contractants désignés :
**CH DE ES FR GB IT LI NL**

(56) Documents cités :
**US-A- 3 379 356**
**PATENT ABSTRACTS OF JAPAN, vol. 9, no. 94 (M-374)[1817], 24 avril 1985; & JP-A-59 220 278**
**PATENT ABSTRACTS OF JAPAN, vol. 10, no. 273 (M-518)[2329], 17 septembre 1986; & JP-A-61 95 768**

(73) Titulaire : **SOCIETE ELECTRONIQUE DE LA REGION PAYS DE LOIRE**
**74, rue du Surmelin**
**F-75020 Paris (FR)**

(72) Inventeur : **Gontier, Bruno**
**THOMSON-CSF SCPI 19, avenue de Messine**
**F-75008 Paris (FR)**

(74) Mandataire : **Chaverneff, Vladimir et al**
**THOMSON-CSF SCPI**
**F-92045 PARIS LA DEFENSE CEDEX 67 (FR)**

## Description

La présente invention a pour objet une machine de soudage à l'étain avec pare-vague automatique, pour cartes à circuit imprimé.

Dans les industries électronique qui fabriquent en grande série des cartes à circuit imprimé, le soudage des composants se fait selon le procédé dit "à la vague", dans lequel une turbine entretient un débit constant d'alliage plomb-étain en fusion, s'écoulant sur un déversoir de forme déterminée.

La forme de la surface de l'alliage en fusion, sa vitesse d'écoulement, et sa propreté sont des facteurs importants qui conditionnent la qualité des soudures.

La géométrie de la carte électronique est aussi un facteur déterminant : idéalement, la carte est plane, et elle aborde dans son mouvement de translation une génératrice rectiligne du volume d'alliage en fusion.

Dans la pratique, les cartes ne sont pas planes, et présentent une forme de tuile d'autant plus accentuée qu'elles sont plus larges. La génératrice du métal en fusion n'est pas non plus rectiligne, et des scories peuvent de plus en altérer la surface.

On comprend que si la carte à souder possède une forme de tuile avec une convexité tournée vers le bas, il y a un très grand risque que le métal en fusion, au moment de l'abordage, inonde le côté composants de la carte, qui est irrémédiable perdue. Si, pour éviter cela, on tente un réglage de compromis, des composants risquent de ne pas être soudés.

Ces raisons font que l'on utilise de coûteux palliatifs, parmi lesquels:
– l'adjonction de raidisseurs sur la carte électronique elle-même ; si c'est une carte contenant des éléments de puissance, on pourra profiter de la rigidité des radiateurs métalliques;
– ou plus généralement l'utilisation d'un cadre de soudage, dans lequel on a emprisonné le circuit, et qui regroupe les fonctions que la carte électronique ne peut remplir par elle-même, et notamment la fonction pare - vague.

On connaît d'après le document US -A-3 379 356 une machine de soudage à buse, qui nécessite, pour éviter l'inondation de la face supérieure des cartes à souder, la fixation sur ces cartes d'un déflecteur (12).

L'invention a pour objet une machine de soudage réalisée de manière à éviter tout surcoût au niveau de la carte, ou des opérations supplémentaires de fabrication telles que mise de la carte dans un cadre, puis retrait après soudage.

La machine de soudage conforme à l'invention est munie d'un dispositif pare-vague solidaire de la machine, qui comporte un dispositif qui fait baisser localement le niveau de la crête d'étain juste avant l'arrivée du bord d'attaque de la carte à souder.

Selon une caractéristique avantageuse de l'invention, le dispositif pare-vague comporte une lame en matériau non fusible à la température de l'étain en fusion, qui s'enfonce dans la surface du bain d'étain devant le bord d'attaque du circuit à souder.

La présente invention sera mieux comprise à la lecture de la description détaillée d'un mode de réalisation, pris à titre d'exemple non limitatif et illustré par le dessin annexé sur lequel :
– la figure 1 est une vue de côté simplifiée et partielle d'une machine de soudage conforme à l'invention, et
– les figures 2 et 3 sont des vues de détail agrandies de la machine de soudage de la figure 1 à deux instants différents du passage d'une carte à circuit imprimé.

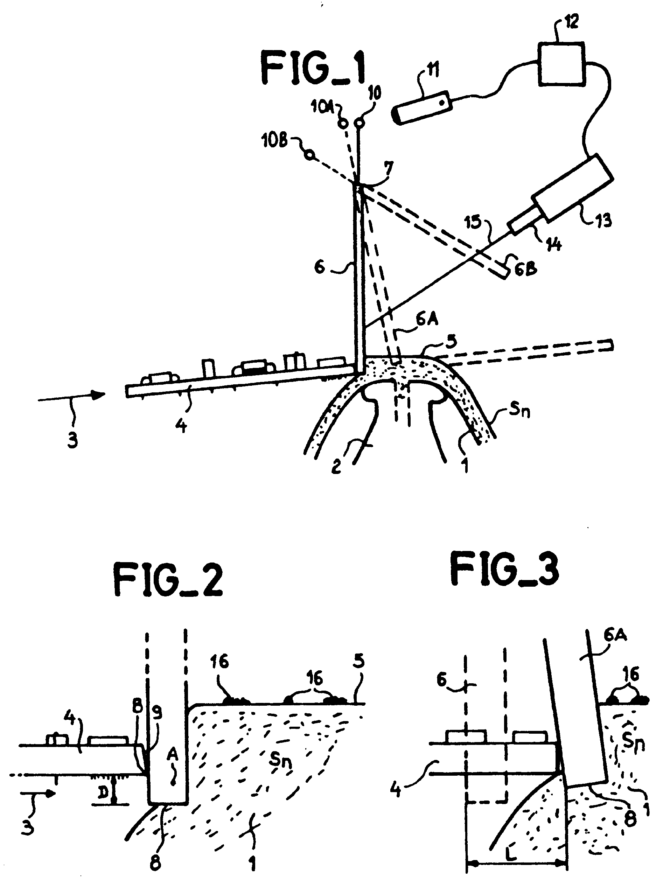

On a schématiquement représenté sur la figure 1 la partie d'une machine de soudage à l'étain se trouvant au niveau de la vague d'étain 1. Par étain, on entend tout produit ou alliage de soudage fusible approprié contenant de l'étain, mais non exclusivement ce seul métal. La vague d'étain 1 est produite de façon classique à l'aide d'une buse 2. Cette vague 1 peut se déverser symétriquement en amont et en aval de la buse, comme représenté sur le dessin, ou bien asymétriquement. On a figuré par une flèche 3 le sens de déplacement du convoyeur de la machine. Ce convoyeur transporte des cartes à circuits imprimés munies de leurs composants, telles que la carte 4 représentée sur le dessin. Les positions relatives du convoyeur et de la buse 2 sont telles que la face supérieure 5 de la vague d'étain 1 est à un niveau supérieur à celui de la face supérieure de la carte 4, ce qui nécessite avec les machines de l'art antérieur des pare-vagues disposés à l'avant des cartes (ou des cadres-supports munis de parois antérieures faisant office de pare-vague) pour éviter l'inondation de la face supérieure de la carte par le bain en fusion.

Selon l'invention, on dispose sur la machine un pare-vague mobile. Dans le mode de réalisation représenté sur le dessin, ce pare-vague comporte un volet 6 mobile en rotation autour d'un axe 7 parallèle aux plans des faces principales de ce volet, axe auquel il est suspendu, cet axe 7 étant perpendiculaire à la direction de déplacement du convoyeur. Le volet 6 a une forme sensiblement rectangulaire, et sa largeur est sensiblement égale à la largeur de la carte 4. Dans sa position de repos (en trait continu sur la figure 1), le volet 6 est disposé de telle façon que sa face latérale inférieure 8 soit à une distance D = 2 à 3 mm environ au-dessous du niveau de la face inférieure de la carte 4, cette face étant donc en dessous du niveau 5. L'axe 7 du volet 6 est disposé à peu près à la verticale d'une ligne A (on en a seulement représenté la trace sur la figure 2) que l'on peut définir comme la position qu'occuperait l'arête d'attaque B de la carte 4 (arête inférieure de la face frontale antérieure 9 de la carte 4) au moment où elle entrerait en contact avec la vague 1 si le volet 6 n'existait pas.

On fixe à la partie supérieure du volet 6 un dispositif de repère 10 coopérant avec un capteur de position 11. Ce capteur 11 peut aussi bien être de type optique qu'électromagnétique ou autre. Le capteur 11 est relié à un dispositif 12 de traitement des informations du capteur et de commande d'un vérin 13 disposé en aval du volet 6. La réalisation du dispositif 12 est évidente pour l'homme de l'art à la lecture de la présente description, et elle dépend du type du capteur 11 et du vérin 13 utilisés. La tige 14 du vérin 13 est reliée au volet 6 par l'intermédiaire d'une liaison souple 15 telle qu'une chaîne ou un câble. Lorsque le vérin 13 est activé par le dispositif 12, il sollicite le volet vers l'aval (c'est-à-dire vers la droite sur le dessin).

Le fonctionnement de la machine décrite ci-dessus est le suivant. Au repos, le volet 6 étant dans la position représentée en trait continu en figures 1 et 2, le convoyeur approche la carte 4 jusqu'au contact avec le volet 6. Le convoyeur continuant à avancer, la carte 4 pousse le volet 6 sur une longueur L = 1 à 2 cm environ sans que rien ne se produise.

Dès que la carte 4 a parcouru la longueur L, le volet 6 arrive dans la position référencée 6A sur les figures 1 et 3, et le dispositif de repère 10 arrive dans la position référencée 10A. A cet instant, le signal fourni par le dispositif capteur 11 atteint un seuil prédéterminé réglé dans le dispositif 12, ce qui fait que ce dernier excite le vérin 13 qui rétracte sa tige 14 et tire ainsi par l'intermédiaire de la liaison 15 sur le volet 6. Les caractéristiques du vérin 13 et de sa commande sont telles qu'il écarte le volet vers l'aval à une vitesse supérieure à celle du déplacement de la carte 4. Le vérin 13 écarte le volet jusqu'à une position 6B (figure 1) telle que ce volet puisse laisser passer la carte 4 sans que les composants ne risquent de toucher le volet.

Le volet 6, au début de son mouvement de la position de repos vers la position finale 6B (tant qu'il est en contact avec la vague d'étain) repousse l'étain pratiquement de la même façon que le faisait un pare-vague classique. Lorsque le volet 6 s'éloigne rapidement de la position 6A vers la position 6B, il repousse l'étain en y créant un "creux" mobile qui précède la carte 4 et lui évite d'être submergée. La crête de vague qui suit ce creux ne "mouille" que la face inférieure de la carte 4 en déposant de la soudure aux endroits désirés.

Les distances D et L, ainsi que le niveau 5 par rapport au niveau de la carte 4, et la vitesse de rétraction du vérin 13 sont réglés expérimentalement de façon à assurer un soudage optimal des queues ou pattes des composants de la carte 4.

Le mouvement du volet 6 a également pour effet d'éloigner de la carte 4 des scories 16 qui pourraient éventuellement se trouver à la surface de la vague d'étain. Un dispositif (non représenté), qui peut soit détecter la fin du passage de la carte 4, soit être activé à la fin d'une temporisation, commande la sortie de la tige 14 du vérin 13.

Selon une variante du mode de réalisation décrit ci-dessus, non représentée, le volet se déplace en une translation rectiligne en restant sensiblement perpendiculaire à la direction 3, puis, lorsque la carte 4 est suffisamment engagée sur la vague 11, le volet est soulevé perpendiculairement à la direction 3, pour être ramené à sa position de "repos" (la même que celle de la figure 1, mais on peut alors avoir D = 0) après le passage de la carte.

Selon un autre mode de réalisation de l'invention, le volet est remplacé par une buse mobile de soufflage de gaz inerte chaud. Cette buse crée un "rideau" de gaz juste devant le carte 4 qu'elle précède, ce rideau de gaz produisant un creux à la surface de la vague d'étain qui empêche l'étain de submerger la carte.

## Revendications

1. Machine de soudage à l'étain avec pare-vague automatique pour cartes à circuit imprimé (4), caractérisée par le fait que le dispositif pare-vague (6) est solidaire de la machine et comporte un dispositif (6) qui fait baisser localement le niveau de la crête d'étain juste avant l'arrivée du bord d'attaque de la carte (4).

2. Machine à souder selon la revendication 1, caractérisée par le fait que le dispositif pare-vague comporte une lame (6) en matériau non fusible à la température de l'étain en fusion qui s'enfonce dans la surface du bain d'étain (1) devant le bord d'attaque du circuit à souder.

3. Machine à souder selon la revendication 2, caractérisée par le fait que la lame est mobile en rotation autour d'un axe (7) perpendiculaire au sens de déplacement (3) de la carte

4. Machine à souder selon la revendication 3, caractérisée par le fait que la lame dans un premier temps de sa rotation, est poussée par la carte (4), puis est rapidement écartée dans le même sens pour laisser passer la carte.

5. Machine à souder selon la revendication 2, caractérisée par le fait que la lame se déplace en une translation rectiligne en restant sensiblement perpendiculaire à la direction de déplacement de la carte, puis est soulevée perpendiculairement à cette direction.

6. Machine à souder selon la revendication 1, caractérisée par le fait que le dispositif pare-vague comporte une buse mobile de soufflage de gaz inerte chaud.

## Patentansprüche

1. Zinn-Lötmaschine mit automatischem Schwallschutz für Karten mit gedruckten Schaltungen (4), dadurch gekennzeichnet, daß die Schwallschutz-Vorrichtung (6) mit der Maschine verbunden ist und eine Vorrichtung (6) aufweist, die die Höhe des Zinnschwall-Scheitelpunktes direkt vor dem Auftreffen auf der Angriffskante der Karte (4) lokal absenkt.

2. Lötmaschine gemäß Anspruch 1, dadurch gekennzeichnet, daß die Schwallschutz-Vorrichtung ein Plättchen (6) aus einem Material, das bei der Schmelztemperatur des Zinns nicht schmelzbar ist, aufweist, das sich vor der Angriffskante der zu lötenden Schaltung in die Oberfläche des Zinnbades (1) eindrückt.

3. Lötmaschine gemäß Anspruch 2, dadurch gekennzeichnet, daß das Plättchen in Drehrichtung um eine zur Verschiebungsrichtung (3) der Karte senkrechte Achse (7) beweglich ist.

4. Lötmaschine gemäß Anspruch 3, dadurch gekennzeichnet, daß das Plättchen während einer ersten Zeitdauer seiner Drehung von der Karte (4) geschoben wird und dann im gleichen Richtungssinn schnell entfernt wird, damit sich die Karte vorbeibewegen kann.

5. Lötmaschine gemäß Anspruch 2, dadurch gekennzeichnet, daß sich das Plättchen in einer geradlinigen Translation verschiebt und dabei im wesentlichen senkrecht zur Verschiebungsrichtung zur Karte bleibt und dann senkrecht zu dieser Richtung hochgehoben wird.

6. Lötmaschine gemäß Anspruch 1, dadurch gekennzeichnet, daß die Schwallschutz-Vorrichtung eine bewegliche Düse zum Ausblasen eines heißen inerten Gases aufweist.

## Claims

1. A soldering machine with an automatic wave guard for printed circuit boards (4), characterized in that the wave guard device (6) is united with the machine and comprises a device (6) which causes a local lowering of the level of the crest of solder just prior to the arrival of the leading edge of the board (4).

2. The soldering machine as claimed in claim 1, characterized in that the wave guard device comprises a blade (6) of a material which does not fuse at the temperature of the molten solder and which dips into the solder bath (1) in front of the leading edge of the circuit to be soldered.

3. The soldering machine as claimed in claim 2, characterized in that the blade is able to be moved in rotation about an axis (7) which is perpendicular to the direction of displacement of the board.

4. The soldering machine as claimed in claim 3, characterized in that during a first period of its rotation the blade is pushed forward by the board (4) and is then rapidly removed in the same direction in order to allow the passage of the board.

5. The soldering machine as claimed in claim 2, characterized in that the blade is moved in rectilinear translation while being maintained substantially perpendicular to the direction of displacement of the board, and is then raised perpendicularly to this direction.

6. The soldering machine as claimed in claim 1, characterized in that the wave guard device comprises a moving blowing jet for hot inert gas.

FIG_1

FIG_2

FIG_3